**Europäisches Patentamt**

**European Patent Office**

**Office européen des brevets**

(19)

(11) **EP 1 615 340 A1**

(12) **EUROPEAN PATENT APPLICATION**

(43) Date of publication:
**11.01.2006 Bulletin 2006/02**

(51) Int Cl.:
*H03H 11/04* *(2006.01)*

(21) Application number: **04291764.1**

(22) Date of filing: **09.07.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(71) Applicant: **ALCATEL**
**75008 Paris (FR)**

(72) Inventors:
• **Moons, Elve Desiderius Jozef**
**3560 Lummen (BE)**

• **Redoute, Jean-Michel Vladimir**
**2600 Berchem (BE)**

(74) Representative: **Narmon, Gisèle Marie Thérèse et al**
**Alcatel Bell N.V.,**
**Francis Wellesplein 1**
**2018 Antwerpen (BE)**

(54) **Method for realising an electronic circuit having a desired filter transfer function and electronic circuit architecture for realising such a filter transfer function**

(57)    Electronic circuit (F) including input terminals (IN1,IN2) and output terminals (OUT1, OUT2) between which a desired filter transfer function (F(s)) is realised by said electronic circuit when an input signal is applied between said input terminals (IN1,IN2) is characterised in that said electronic circuit (F) includes at least one first passive series element (Z1) having a first series impedance, a first terminal of which is coupled to one of said input terminals (IN1), a second terminal of which is coupled to one of said output terminals (OUT1), said electronic circuit further including an active circuit (G) coupled between said output terminals (OUT1,OUT2), and including a filter circuit (H) with a filter transfer function (H(s)) such that said desired filter transfer function (F(s)) is obtained.

Fig. 1

**Description**

The present invention relates to an electronic circuit as described in the preamble of claim 1, and to a method for realising such an electronic circuit as is described in the preamble of claim 13.

Methods and electronic circuits for realising a desired filter transfer function have been described extensively in the past. Amongst them one can count the classical components-based filter realisations using discrete electronic components as resistors, capacitors and inductors, such as the Chebychev, Butterworth and other filter techniques. Also active filter methods using operational amplifiers and switch-capacitor techniques have been extensively described in literature.

A drawback of the discrete filter realisations is that they are using lumped elements, more in particular lumped inductors. These are bulky and expensive. Although attempts were made in the past years to integrate these devices on silicon, they still remain bulky and consume a lot of integrated circuit area, especially when they have to withstand high voltages and currents.

Active filters can be implemented as part of an integrated circuit. However filters that are to operate at high voltages and currents are generally not realisable by means of active filters since they would also require expensive high voltage technologies.

Another method for realising filters, as used for instance in splitters in telephone circuits, was described in the published PCT patent application WO 03/061121. Therein the low-pass filter of a splitter on a telephone line is realised as an active element in series on each transmission line and preceded on the line side by an inductance type passive element. A drawback of this method is that the active elements in the series path between input and output contribute to a series voltage drop which is undesirable.

It is therefore an object of the present invention to provide an electronic circuit and a method for realising such an electronic circuit of the above known kind, but which is able to operate at high voltages and which does not have a series voltage drop associated with it.

According to the invention this object is realised by the fact that the electronic circuit is further realised as described in the characterising portion of claim 1, by means of the method as described in the characterising portion of claim 13.

In this way, the filter transfer function is almost completely realised by means of an active circuit between the output terminals, whereas the series path between the input and output terminals only contains at least one passive component. This passive component can be a simple resistor or an inductor, or a combination of both or any passive circuit , but these can be selected such as to have only a very small DC series resistance. The active circuit is thus realised as a parallel circuit between the output terminals, and is selected such that the total transfer function of the combination of the series impedance of this at least one passive series component and the parallel active circuit matches the desired transfer function. With active circuit is meant any circuit including at least one active element such as a transistor. Generally speaking, in order to realise any filter function F(s), the active parallel circuit G thereby includes another filter having a filter transfer function H(s). The active circuit G, combined with the previously described series impedance, forms the total F(s).

In a preferred embodiment both series branches between corresponding input and output terminals include such a series impedance as is described in claim 2 , whereby both series impedances can be further made substantially identical, as is set out in claim 3 .

In order to realise a desired high pass filter function, the active parallel circuit thereby has to include a low pass filter, as described in claim 4 , in order to realise a desired bandpass filter function, the parallel circuit also has to include a band-reject filter, as set out in claim 5 , in order to realise a desired low pass filter function, the active parallel circuit has to include a high pass filter as set out in claim 6 , and in order to realise a desired band-reject filter function, the active parallel circuit has to include a band pass filter as set out in claim 7. Throughout this document we refer to the standard tutorial handbook "Handbook of Filter Synthesis" by A.I. Zverev, J.Wiley and Sons, ISBN 0471 98680 1 with respect to these definitions for particular types of filters.

In a particular embodiment the desired low pass filter function is the low pass filter part of a splitter circuit in telephone transmission lines, as set out in claim 8. A particular characteristic of such a low pass filter circuit in a splitter circuit is that it is bidirectional, meaning that in this case a filter transfer is to be observed from input to output terminals and vice versa, meaning that in such a bidirectional circuit input and output terminals are interchangeable to some respect. Remark that the transfer function in one direction need not be the same as the transfer function in the other direction.

For realising bi-directionality, at least two passive series elements are to be present, surrounding the active circuit as set out in claim 9. Claim 10 states that, for a balanced solution at least four passive series elements are foreseen, which are preferrably equal.

Claim 11 further states that the active circuit can be coupled to the the secondary windings of a transformer, of which the primary windings are coupled between the output terminals. This has as further advantage that the active circuit can be powered at low voltages, by virtue of the transformer ratio, such that any active circuit can then further be more easily realised , for example by means of the earlier described active switch capacitor filter techniques, or even using digital filter techniques or synthesising the active circuit with discrete elements.

Claim 12 states that the active circuit is coupled to at least one of the output terminals via a capacitor in between this output terminal and an input terminal of this active circuit. This configuration has the advantage that DC voltage or low frequency signals are filtered out by the capacitor before reaching the active circuit, and is thus particularly useful for realising an overall low-pass transfer function where the active circuit is thus to include a high pass filter.

It is to be noticed that the term 'coupled', used in the claims, should not be interpreted as being limitative to direct connections only. Thus, the scope of the expression 'a device A coupled to a device B' should not be limited to devices or systems wherein an output of device A is directly connected to an input of device B. It means that there exists a path between an output of A and an input of B which may be a path including other devices or means.

It is to be noticed that the term 'comprising', used in the claims, should not be interpreted as being limitative to the means listed thereafter. Thus, the scope of the expression 'a device comprising means A and B' should not be limited to devices consisting only of components A and B. It means that with respect to the present invention, the only relevant components of the device are A and B.

The above and other objects and features of the invention will become more apparent and the invention itself will be best understood by referring to the following description of an embodiment taken in conjunction with the accompanying drawings wherein

Figure 1 gives a basic scheme of electronic circuit according to the invention,
Figure 2 schematically depicts bidirectional implementations of an overall low-pass filter, such as useful in a splitter circuit ,
Figures 3a-3c schematically depicts the method for realising particular embodiments of the electronic circuit architecture according to the invention
Figure 4 gives an embodiment of an electronic circuit according to the invention, including a transformer, and
Figue 5 depicts an embodiment of an electronic circuit according to the invention including extra capacitors.

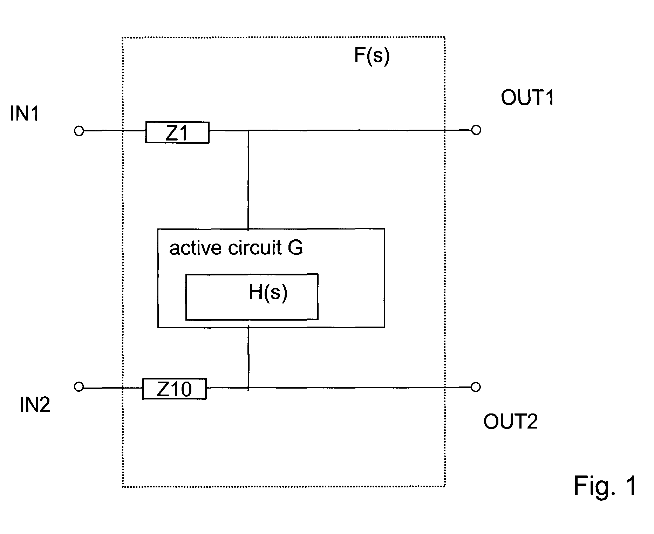

The present invention concerns a method for realising or designing an electronic circuit F having a particular desired filter characteristic F(s), as well as the electronic circuit architecture itself. The basic principle schematic is shown in Fig. 1 wherein a two-port system with a desired filter characteristic, for instance a low-pass filter , has to be realised between the output ports OUT1 and OUT2, and the input ports IN1 and IN2. If this particular filter characteristic is to be represented by its Laplace transform F(s), then the following relationship exists :

$$ Vout1(s) - Vout2(s) = F(s)\,[Vin1(s) - Vin2(s)] \qquad (1) $$

With Vout1 being the voltage at output terminal OUT1
With Vout2 being the voltage at output terminal OUT2
With Vin1 being the voltage at output terminal IN1
With Vin2 being the voltage at output terminal IN2 and
With s being the Laplace variable

Various methods have been described in the past for realising such a filter, either based on lumped discrete elements, either based on active or even digital filters. The method of the present invention is based on the principle as depicted in Fig. 1, namely that passive elements are placed in one or both of the series paths between the inputs and outputs, and that an active circuit G is placed in the parallel path between the outputs. This active circuit G includes a filter H such that with this realisation the total desired filter characteristic F(s) is obtained.

In Fig. 1 these passive series elements are represented and respectively denoted Z1 and Z10, but embodiments exist where only one of both series impedances is present. The parallel active circuit G includes a filter block H, with a transfer function H(s), where G is to be coupled between the terminals OUT 1 and OUT2.

It can be mathematically shown , and examples will be given in a further paragraph, that, for a desired total low pass system filter characteristic F(s), the parallel active circuit G has to include a high pass filter. Similarly, in order to realise a desired bandpass filter function F(s), the parallel circuit has to include a band-reject filter function H(s); in order to realise a desired low pass filter function, the active parallel circuit has to include a high pass filter , and in order to realise a desired band-reject filter function, the active parallel circuit has to include a band pass filter function . In this respect it is further to be remarked that the filter characteristics H(s) of the filters H included in the active circuits G are not the pure inverse characteristic of the desired overall filter transfer function F(s), as will become clear from the examples in a further paragraph.

The passive series impedance elements Z1, Z10 can comprise one element such as a resistor, inductor or capacitor, or comprise a series connection of several components . The total series impedance of the series connection is represented by Z1, respectively Z10.

In a preferred embodiment the series impedance in the path between OUT1 and IN1 has to match the series impedance in the path between OUT2 and IN2. A balanced solution then requires Z1 to equal Z10 . In case Z1 differs from Z10 the solution is unbalanced .

This method for designing a filter is particularly interesting for these applications wherein the filter has to withstand high currents and voltages. This is for instance the case in the low pass filter part of splitter circuits in telephone circuits. These circuits were extensively discussed in the already mentioned published PCT patent application WO 03/061121 and their function will therefore not be repeated in this document. A further requirement of these low-pass filters in splitters is that the low-pass filter characteristic has to be bi-directional, meaning that both in the direction from input to output, as well as in the direction from output to input, a filter characteristic is observed. Both observed filter characteristics may be identical, but this is not mandatory.

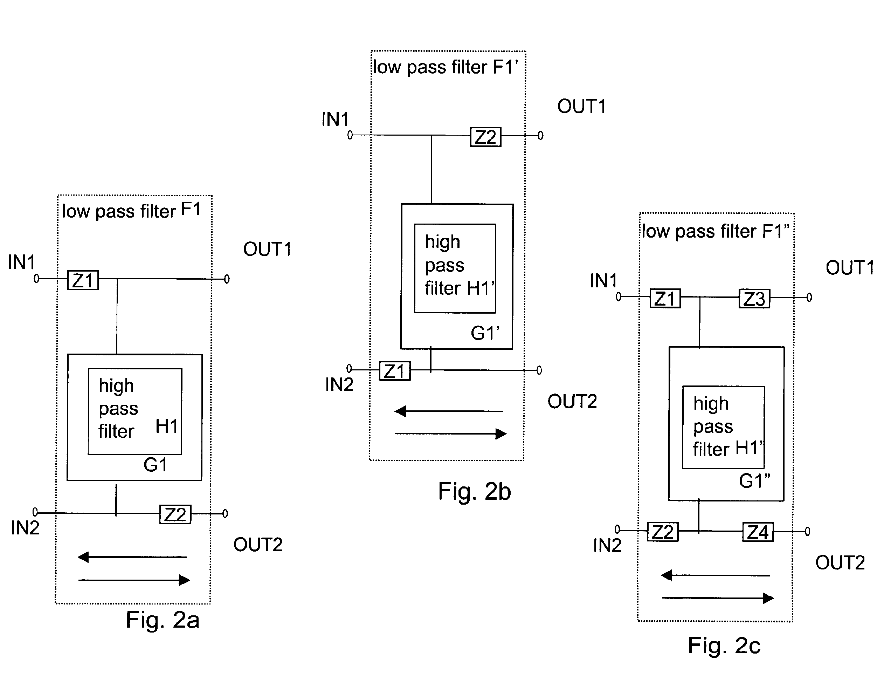

This bi-directionality is denoted on Figs. 2a to 2c by the bi-directional arrow in the total system transfer block , indicating that low-pass filter characteristics are seen in both directions. Fig. 2a depicts a first bi-directional embodiment with a series element in the upper left, and the lower right branch. Fig. 2b depicts a second bi-directional embodiment with a series element in the lower left and the upper right branch. Fig. 2c shows an embodiment including third and fourth series impedances in the series branches between inputs and outputs, mainly added for balancing purposes. In this case they are all substantially equal to each other.

Although the examples depicted in Figs 2a-2c are shown for low-pass filters, the principles as set out in the previous paragraphs are as well applicable for realising any kind of bi-directional filter.

For a splitter circuit, the series passive elements may comprise simple resistors, lumped inductors or capacitors a combination of all of them

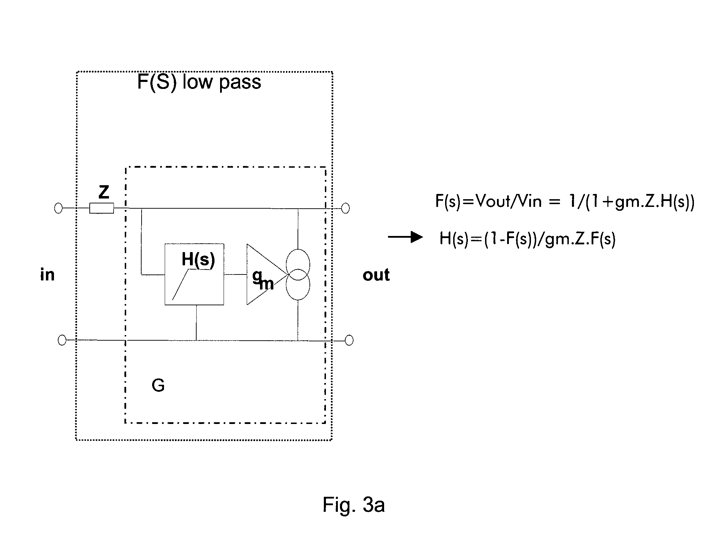

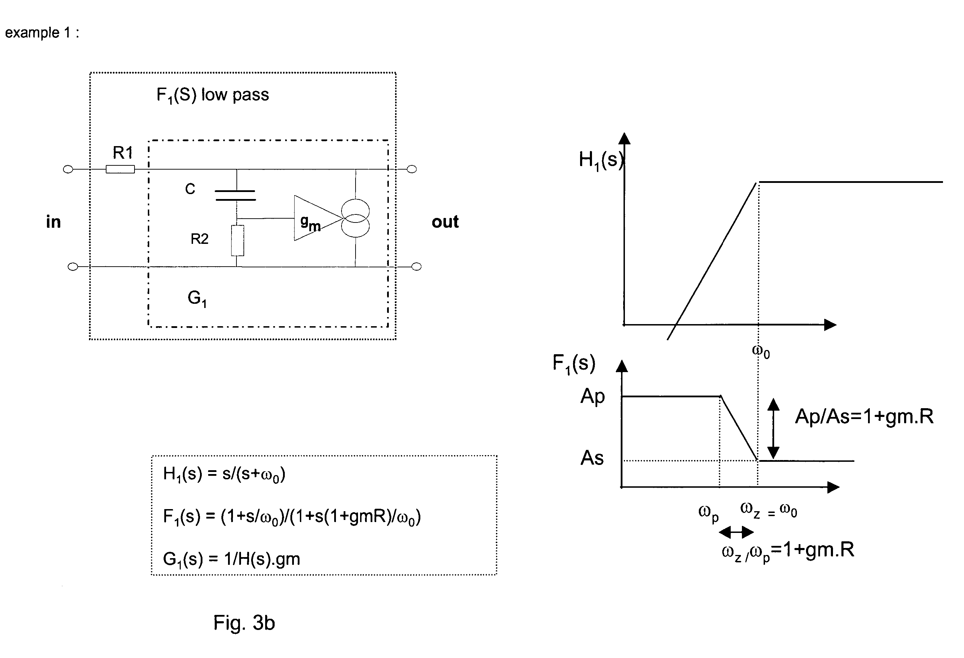

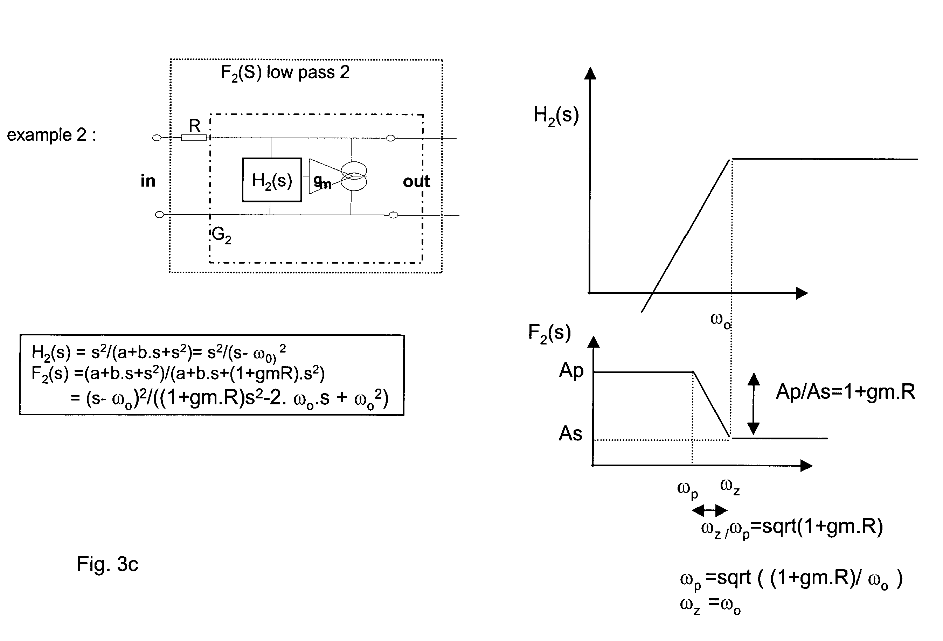

Examples of embodiments for further realising a low-pass function into detail are shown in fig. 3a to 3c. Fig. 3a depicts the general principle of recalculating the filter part H(s) of an active circuit G from the desired total transfer function F(s). In the examples shown in Fig. 3 the active circuit G is composed of a filter H followed by an active transconductance circuit denoted gm. However other embodiments for realising the active circuit G are possible. The overall transfer function for F is denoted as

$$F(s) = Vout/Vin = 1/(1 + gm.Z.H(s)) \qquad (2)$$

For a desired F(s), such as a desired low-pass function, one can calculate the corresponding H(s) :

$$H(s) = (1 - F(s))/gm.Z.F(s) \qquad (3)$$

once H(s) is mathematically known, it has to be synthesised, using known techniques. In general an iterative approach is used, by first selecting a particular and simply realisable H(s), taking into account the already mentioned principles , and then further calculating the resulting F(s) :

This is shown in example 1 in Fig. 3b, where in order to obtain a low-pass filter characteristic F1(s) a simple high pass filter function H1(s) is selected, consisting of a capacitor C and a resistor R2.

According to the definition of a low-pass filter function :

H1 (s) approximates 1 for frequencies larger than the cut-off frequency $\omega_o$

For these high frequencies , equation (2) will result in

$$F1(s) = Vout/Vin = 1/(1 + gm.Z) \qquad (4)$$

thus for high frequencies larger than $\omega_o$, F1 acts as an impedance divider, with a high attenuation provided gm.Z is large.

According to the definition of a low-pass filter

H1 (s)=0 for frequencies lower than the cut-off frequency $\omega_o$

For these low frequencies equation (2) results in

$$F1(s) = Vout/Vin = 1 \qquad (5)$$

Indicative of the pass band of F1.

At intermediate frequencies : F1 (s) will show a transistion region from pass band to stop band transition , with a slope related to the order of the high pass filter H1.

For the particular embodiment depicted in Fig. 3b, wherein Z1 consists of a simple resistor R1, and the low-pass filter H1 is a first order low-pass filter with transfer function $H1(s) = s/(\omega_0 + s)$ where $\omega_0 = 1/(R2.C)$, the obtained overall transfer function F1 (s) is then

$$F1(s) = Vout/Vin = (1 + s/\omega_0) / (1 + s(1 + gm.R1)/\omega_0) \qquad (6)$$

For low frequencies (s=0) : Vout/Vin=1 , showing the pass band

For high frequencies (s=∞) : Vout/Vin=1/1 +gm.R1 , showing the resistive voltage divider with 1/gm and R, thus corresponding to the stop band attenuation

F1 (s) has thus a pole at $\omega_p = \omega_0/(1 + gm.R1)$ and a zero at $\omega_z = \omega_0$

and a transition region corresponding to a first order slope between $\omega_p$ and $\omega_z$ as can be observed from Fig. 3b.

In example 2, depicted in Fig. 3c another high-pass function H2(s) is chosen :

$$H2(s) = s^2/(a + b.s + s^2) \qquad (7)$$

having the characteristics of a 2nd order high pass filter

The resulting F2(s) has then, according to equation (2) the following tranfer function :

$$F2(s) = Vout/Vin = (a + b.s + s^2)/( (a + b.s + (1 + gm.R)s^2) \qquad (8)$$

for low frequencies (s=0) F2(s) =Vout/Vin=1, showing the pass band of F2. for high frequencies (s=∞) F2(s)=: Vout/Vin=1/(1 +gm.R) being indicative of a resistive voltage divider with 1/gm and R, thus corresponding to the stop band attenuation of F2.

Poles of F2(s) at located at a location with a factor (1 +gm.R) lower than the zeros Zeroes of F2(s) are located at the same location as the poles of the high pass filter H2(s).

A second order slope between poles and zeros is then present.

In Fig. 3c a particular situation is shown wherein the two poles of the filter H2(s) are coinciding. So the Bode plot of H2(s) only shows one pole at $\omega_0$. This pole corresponds to the single zero of F2(s), and the other relationships between the pole and zero of F2(s) and $\omega_0$ are indicated in this figure.

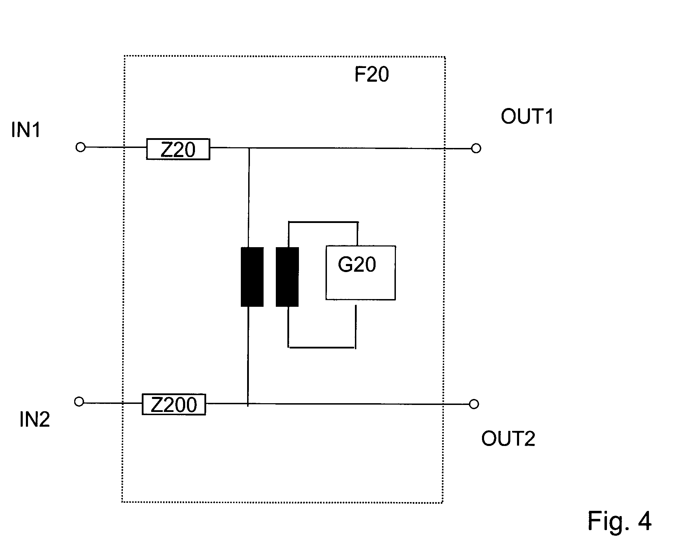

In other embodiments of the invention, such as circuit F20 shown in Fig. 4, the parallel active circuit G20 can be coupled to the output terminals via the secondary windings of a transformer T, of which the primary windings are coupled between the output terminals. This has the advantage that the active circuit can still be powered at lower voltages. Used within splitters, this configuration has even more advantages due to the inductive windings of the transformer

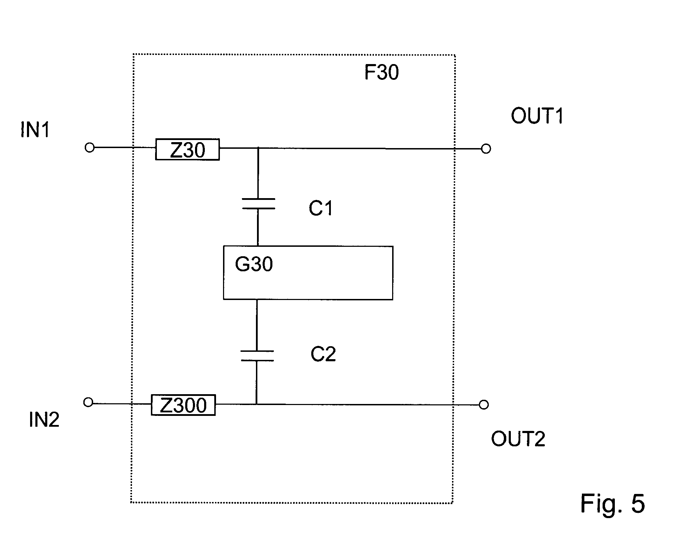

In yet other embodiments, such as F30 shown in Fig. 5 , the active circuit G30 is coupled via one or more series capacitors. In Fig. 5 two series capacitors C1 and C2 are shown, but embodiments exits where only such, such as merely C 1, is present , in between on of the output terminals OUT1,OUT2 and the active circuit G30. This configuration has a particular advantage for low-pass splitters wherein the parallel circuit G30 including the high-pass filter is further shielded from DC and low frequency (high voltage) signals..

Nothwithstanding the shown examples, the invention is not linked to any particular filter implementation, but is generally useably to any kind of filter. Thus any combination of low,high, bandpass filter is as well realisable using the the previously described principles.

While the principles of the invention have been described above in connection with specific apparatus, it is to be clearly understood that this description is made only by way of example and not as a limitation on the scope of the invention, as defined in the appended claims.

**Claims**

1.  Electronic circuit (F) including input terminals (IN1,IN2) and output terminals (OUT1, OUT2) between which a desired filter transfer function (F(s))is realised by said electronic circuit when an input signal is applied between said input terminals (IN1,IN2)
    **characterised in that** said electronic circuit (F) includes at least one first passive series element (Z1) having a first series impedance, a first terminal of which is coupled to one of said input terminals (IN1), a second terminal of which is coupled to one of said output terminals (OUT1), said electronic circuit further including an active circuit (G) coupled between said output terminals (OUT1,OUT2), and including a filter circuit (H) with a filter transfer function (H(s)) such that said desired filter transfer function (F(s)) is obtained.

2.  Electronic circuit (F) according to claim 1 further including at least one second passive element (Z10) having a second series impedance , a first terminal of which is coupled to the other of said input terminals (IN2), a second terminal of which is coupled to the other of said output terminals (OUT2).

3.  Electronic circuit according to claim 1 wherein said first series impedance (Z1) has substantially the same value as said second series impedance (Z10).

4.  Electronic circuit (F) according to any of the previous claims 1 to 3 and wherein, for said desired filter transfer function (F(s)) of said electronic circuit (F) being a high pass filter transfer function , said active circuit (G) is such as to include a filter (H) with a low pass filter transfer function.

5.  Electronic circuit (F) according to any of the previous claims 1 to 3 and wherein, for said desired filter transfer function of said electronic circuit (F) being a band pass filter transfer function, said active circuit (G) is such as to include a filter (H) with a band-reject filter transfer function.

6.  Electronic circuit (F) according to any of the previous claims 1 to 3 and wherein, for said desired filter transfer function (F(s)) of said electronic circuit (F) being a low pass filter transfer function , said active circuit (G) is such as to include a filter (H) with a high pass filter transfer function (H(s)) .

7.  Electronic circuit according (F) to any of the previous claims 1 to 3 and wherein, for said desired filter transfer function of said electronic circuit (F) being a band reject filter transfer function, said active circuit (G) is such as to include a filter (H) with a band-pass filter transfer function (H(s)).

8.  Electronic circuit according to claim 6 wherein said electronic circuit is part of a low pass filter comprised in a splitter circuit used in a telephone line.

9.  Electronic circuit (F1; F1')according to any of the previous claims 1 to 8 wherein said electronic circuit is such as to further realise an additional filter transfer function in the other direction from output terminal to input terminals thereby further including at least one additional passive series elements (Z2), such that the first passive series element (Z1) is coupled between an input terminal (IN1) and a first terminal of said active circuit (G1; G1'), and a second passive series element (Z2) is coupled between a second terminal of said active circuit and an output terminal (OUT2).

10. Electronic circuit (F1") according to claim 8 including at least two additional passive series elements, (Z3, Z4) a first one (Z3) of which is being coupled in series between the other input terminal (IN2) and said second terminal of said active circuit, a second one (Z4) of which is being coupled in series between said first terminal of said active circuit and the other output terminal (OUT1).

11. Electronic circuit (F20) according to any of the previous claims 1 to 10 wherein said active circuit (G20) is coupled to the secondary windings of a transformer (T) of which the first windings are coupled between said output terminals (OUT1, OUT2).

12. Electronic circuit (F30) according to any of the previous claims 1 to 10 wherein said active circuit (G30) is coupled between said output terminals via at least one capacitor (C1) in series between said active circuit (G30) and one of said output terminals (OUT1).

13. Method for realising an electronic circuit (F) having a desired filter transfer function F(s) between input terminals and output terminals, said method including a step of selecting at least one series impedance (Z1) to be placed in series between one of said input terminals (IN1) and one of said output terminals (OUT1) and a further step of realising an active circuit (G) to be placed between said output terminals and including a filter (H) such that the filter transfer function (F(s)) of said electronic circuit (F(s))is obtained.

Fig. 1

F(s)

OUT1

active circuit G

H(s)

Z1

OUT2

Z10

IN1

IN2

low pass filter F1"

OUT1

Z3

Z1

high pass filter H1"

G1"

Z4

Z2

IN1

IN2

OUT2

Fig. 2c

low pass filter F1'

OUT1

Z2

high pass filter H1'

G1'

Z1

IN1

IN2

OUT2

Fig. 2b

low pass filter F1

OUT1

Z1

high pass filter H1

G1

Z2

IN1

IN2

OUT2

Fig. 2a

$$F(s)=Vout/Vin = 1/(1+gm.Z.H(s))$$

$$H(s)=(1-F(s))/gm.Z.F(s)$$

Fig. 3a

$H_1(s)$

$\omega_0$

$F_1(s)$

$Ap$

$As$

$Ap/As=1+gm.R$

$\omega_z = \omega_0$

$\omega_p$

$\omega_z/\omega_p=1+gm.R$

example 1 :

$F_1(S)$ low pass

out

in

R1

C

$g_m$

R2

$G_1$

$H_1(s) = s/(s+\omega_0)$

$F_1(s) = (1+s/\omega_0)/(1+s(1+gmR)/\omega_0)$

$G_1(s) = 1/H(s).gm$

Fig. 3b

example 2 :

F$_2$(S) low pass 2

in    R    H$_2$(s)    g$_m$    out

G$_2$

$$H_2(s) = s^2/(a+b.s+s^2)= s^2/(s- \omega_{0)}{}^2$$
$$F_2(s) =(a+b.s+s^2)/(a+b.s+(1+gmR).s^2)$$
$$= (s- \omega_o)^2/((1+gm.R)s^2-2. \omega_o.s + \omega_o{}^2)$$

Fig. 3c

H$_2$(s)

$\omega_o$

F$_2$(s)

Ap

As

Ap/As=1+gm.R

$\omega_p$  $\omega_z$

$\omega_z/\omega_p$=sqrt(1+gm.R)

$\omega_p$ =sqrt ( (1+gm.R)/ $\omega_o$ )
$\omega_z$ =$\omega_o$

Fig. 4

EP 1 615 340 A1

Fig. 5

**European Patent Office**

## EUROPEAN SEARCH REPORT

Application Number

EP 04 29 1764

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 6 748 076 B1 (ELO HARRI) 8 June 2004 (2004-06-08) * the whole document * ----- | 1-13 | H03H11/04 |
| X | EP 0 377 300 A (RAYTHEON CO) 11 July 1990 (1990-07-11) * figure 4 * ----- | 1-10,12, 13 | |
| X | WO 01/10023 A (TUCKER ANDREW CECIL ; ROXBURGH ELECTRONICS LTD (GB)) 8 February 2001 (2001-02-08) * figure 1 * ----- | 1,13 | |
| X | EP 1 401 095 A (CIT ALCATEL) 24 March 2004 (2004-03-24) * figures 1,2 * ----- | 1,13 | |
| A | WALTER E. HEINLEIN AND W. HARVEY HOLMES: "Active filters for integrated circuits" 1974, R. OLDENBOURG , XP002311632 ISBN: 3486344617 * page 108 - page 127 * ----- | 1-13 | TECHNICAL FIELDS SEARCHED (Int.Cl.7)  H03H |
| A | US 5 001 441 A (GEN-KUONG FERNANDO) 19 March 1991 (1991-03-19) * the whole document * ----- | 1-13 | |

The present search report has been drawn up for all claims

| Place of search | Date of completion of the search | Examiner |
|---|---|---|
| Munich | 21 December 2004 | Naumann, O |

EPO FORM 1503 03.82 (P04C01)

## ANNEX TO THE EUROPEAN SEARCH REPORT
## ON EUROPEAN PATENT APPLICATION NO.

EP 04 29 1764

This annex lists the patent family members relating to the patent documents cited in the above-mentioned European search report.
The members are as contained in the European Patent Office EDP file on
The European Patent Office is in no way liable for these particulars which are merely given for the purpose of information.

21-12-2004

| Patent document cited in search report | | Publication date | Patent family member(s) | | Publication date |
|---|---|---|---|---|---|
| US 6748076 | B1 | 08-06-2004 | FI | 981319 A | 11-12-1999 |
| | | | AU | 4783899 A | 30-12-1999 |
| | | | EP | 1086575 A1 | 28-03-2001 |
| | | | WO | 9965217 A1 | 16-12-1999 |
| EP 0377300 | A | 11-07-1990 | US | 5021756 A | 04-06-1991 |
| | | | DE | 68921330 D1 | 30-03-1995 |
| | | | DE | 68921330 T2 | 19-10-1995 |
| | | | EP | 0377300 A2 | 11-07-1990 |
| | | | JP | 2028976 C | 19-03-1996 |
| | | | JP | 2228115 A | 11-09-1990 |
| | | | JP | 7067061 B | 19-07-1995 |
| WO 0110023 | A | 08-02-2001 | GB | 2352894 A | 07-02-2001 |
| | | | AU | 6304600 A | 19-02-2001 |
| | | | EP | 1208644 A1 | 29-05-2002 |
| | | | WO | 0110023 A1 | 08-02-2001 |
| | | | JP | 2003506947 T | 18-02-2003 |
| EP 1401095 | A | 24-03-2004 | EP | 1401095 A1 | 24-03-2004 |
| | | | US | 2004056713 A1 | 25-03-2004 |
| US 5001441 | A | 19-03-1991 | NONE | | |

EPO FORM P0459

For more details about this annex : see Official Journal of the European Patent Office, No. 12/82